# FASCICULE DE BREVET EUROPEEN

(11) **EP 3 168 983 B1**
(45) Date de publication et mention de la délivrance du brevet: **17.10.2018**
(21) Numéro de dépôt: 15194566.4
(22) Date de dépôt: 13.11.2015
(51) Int. Cl.: H03C 3/09

(54) **PROCÉDÉ DE CALIBRATION D'UN SYNTHÉTISEUR DE FRÉQUENCE À MODULATION FSK À DEUX POINTS**
KALIBRIERUNGSVERFAHREN EINES FREQUENZSYNTHESIZERS MIT FSK-MODULATION AN ZWEI PUNKTEN
METHOD FOR CALIBRATING A FREQUENCY SYNTHESIZER WITH TWO-POINT FSK MODULATION

(43) Date de publication de la demande: 17.05.2017
(73) Titulaire: The Swatch Group Research and Development Ltd., 2074 Marin (CH)
(72) Inventeur: Casagrande, Arnaud, 2014 Bôle (CH)
(74) Mandataire: Giraud, Eric

(56) Documents cités:
- EP-A2- 0 423 941
- US-A1- 2006 055 467
- US-A1- 2008 007 346
- US-A1- 2009 153 254
- US-A1- 2009 219 100
- US-A1- 2009 295 493
- US-A1- 2010 066 459
- US-B1- 6 515 553

## Description

### Domaine de l'invention

L'invention concerne un procédé de calibration d'un synthétiseur de fréquence à modulation à deux points notamment dans un émetteur-récepteur de signaux radiofréquences FSK.

L'invention concerne également un émetteur-récepteur de signaux radiofréquences avec un synthétiseur de fréquence à modulation à deux points pour la mise en oeuvre du procédé de calibration.

### Arrière-plan de l'invention

Pour la transmission ou réception de données ou commandes par exemple à courte distance, un émetteur-récepteur conventionnel utilise une modulation du type FSK (Frequency Shift Keying en terminologie anglaise). Si la fréquence porteuse RF est élevée, par exemple de l'ordre de 2.4 GHz, une largeur de bande assez élevée est choisie pour la fréquence intermédiaire, notamment supérieure ou égale à 200 kHz. La déviation de fréquence de modulation dans les signaux modulés peut être adaptée en fonction de cette largeur de bande. Dans ce cas de figure, il peut être utilisé une référence de fréquence fournie par un oscillateur local, qui peut ne pas être très précise et donc bon marché. Cependant il doit être tenu compte de la puissance du bruit thermique, qui est proportionnelle à cette largeur de bande choisie. Ainsi un système de transmission ou réception à large bande n'a en général pas une excellente sensibilité.

Dans la demande de brevet EP 0 961 412 A1, il est décrit un synthétiseur de fréquence pour une modulation de fréquence à deux points pour la transmission de données. Ce synthétiseur de fréquence utilise un modulateur du type sigma-delta pour la modulation de données en commandant un diviseur variable dans la boucle à verrouillage de phase basse fréquence, et un convertisseur numérique-analogique DAC pour la modulation haute fréquence. Ce convertisseur DAC a un gain variable, qui est réglé par une unité à commande numérique, et est commandé par un signal de commande numérique pour la modulation en fréquence des données. Ce signal de commande numérique est également transmis au modulateur sigma-delta pour combiner la modulation de la boucle basse fréquence et celle fournie par le convertisseur DAC.

Dans ce synthétiseur, il est opéré une variation du retard relatif du signal de modulation passant par le convertisseur DAC par rapport à la modulation dans la boucle basse fréquence. Cependant, rien n'est décrit dans ce document concernant par exemple une adaptation du niveau d'amplitude du spectre des données modulées par la boucle à verrouillage de phase basse fréquence et par l'intermédiaire du convertisseur DAC. Il peut ainsi survenir des interférences non désirées en fonction de la fréquence de transition d'état pour la transmission des données. De plus, l'adaptation du gain du convertisseur DAC est relativement compliquée à mettre en oeuvre, ce qui constitue un inconvénient.

Dans le brevet EP 2 173 029 B1, il est décrit un procédé d'auto-calibration d'un synthétiseur de fréquence à modulation FSK du type à deux points pour la transmission de données. Le synthétiseur de fréquence comprend une première boucle à verrouillage de phase basse fréquence dans laquelle est placé un oscillateur commandé en tension, et un accès haute fréquence, qui comprend un convertisseur numérique-analogique, relié à l'oscillateur commandé en tension. La première boucle à verrouillage de phase comprend encore un oscillateur de référence, un comparateur de phase relié à l'oscillateur de référence, un premier filtre de boucle passe-bas, et un compteur diviseur multimode commandé par un modulateur pour fournir au comparateur de phase un signal divisé sur la base d'un signal haute fréquence de sortie du synthétiseur. L'oscillateur commandé en tension est commandé à une première entrée par un premier signal de tension de commande provenant du premier filtre de boucle, et à une seconde entrée par un second signal de tension de commande pour la modulation de données haute fréquence.

Pour le procédé d'auto-calibration du synthétiseur de fréquence du brevet EP 2 173 029 B1, il est décrit un algorithme d'adaptation du gain d'un convertisseur numérique-analogique DAC par dichotomie. Il est effectué une comparaison de tensions continues dans un autre comparateur pour commander une logique d'adaptation du gain du DAC. Toutes les opérations pour calibrer le gain du DAC sont effectuées en boucle ouverte de la première boucle à verrouillage de phase basse fréquence. Des dérives en tension surviennent lors du fonctionnement en boucle fermée. De ce fait, cela crée des écarts de tensions et un déphasage de signaux à filtrer avant l'oscillateur commandé en tension dans le fonctionnement en boucle fermée après calibration. De plus, la calibration du synthétiseur est longue, ce qui constitue des inconvénients. Les documents US2008/007346 et US2009/219100 divulguent des emetteur-récepteurs de signaux radiofréquences à base de boucles à verrouillage de phase. Dans les deux documents, une modulation à deux points est effectuée par un modulateur sigma-delta et un convertisseur numérique-analogique et une procédure de calibration en deux phases est décrite.

Il est également connu un synthétiseur de fréquence à modulation à deux points, où les opérations de calibration du modulateur à deux points sont effectuées en minimisant la puissance en sortie du filtre de boucle ou en sortie du convertisseur DAC. Dans un mode de calibration, il peut aussi être minimisé la tension en sortie du filtre de boucle par un algorithme des moindres carrés de type LMS (Least-Mean Square en terminologie anglaise) en contrôlant le gain du convertisseur DAC. Cela nécessite une structure du circuit compliquée, ce qui constitue un inconvénient.

### Résumé de l'invention

L'invention a donc pour but de fournir un procédé de calibration d'un synthétiseur de fréquence à modulation à deux points, qui soit facile à mettre en fonction et rapide d'exécution avec une calibration en boucle fermée et palliant les inconvénients de l'état de la technique susmentionné.

A cet effet, l'invention concerne un procédé de calibration d'un synthétiseur de fréquence à modulation à deux points, qui comprend les caractéristiques mentionnées dans la revendication indépendante 1.

Des étapes particulières du procédé de calibration sont définies dans les revendications dépendantes 2 à 7.

Un avantage du procédé de calibration réside dans le fait que la boucle à verrouillage de phase du synthétiseur est dans un état fermé pour effectuer les étapes du procédé de calibration. Cela évite des écarts de tension comme observé dans l'état de la technique susmentionné pour une calibration en boucle ouverte.

Avantageusement, uniquement deux phases de calibration sont nécessaires. Dans une première phase, il est adapté l'écart de phase dans la partie analogique du synthétiseur depuis la fourniture du signal d'excitation à l'unité de calibration. Le signal déphasé dans cette première phase est ramené sur un des axes de la constellation des états de phase I et Q, de préférence sur l'axe I (cosinus). Ainsi une projection sur l'axe I est effectuée dans la première phase. Dans une seconde phase, une fois que l'écart de phase est logiquement ramené à 0 dans l'unité de calibration, le gain du convertisseur numérique-analogique DAC est adapté au moyen d'un algorithme par dichotomie. Suite à la correction de l'écart de phase de la première phase, seulement le contrôle de la polarité du signal en sortie du filtre de boucle peut être effectué dans la seconde phase. Ce contrôle de la polarité dans l'unité de calibration permet de savoir si le gain du DAC est trop grand ou trop petit pour l'adapter facilement.

Avantageusement, après correction de l'écart de phase par contrôle des passages par zéro du signal entrant dans l'unité de calibration, il n'est ainsi plus nécessaire de minimiser la puissance de fonctionnement pour la calibration du gain du DAC. Avec les deux phases de calibration, il y a une suppression active du bruit dans la boucle à verrouillage de phase.

Avantageusement pour effectuer la calibration du synthétiseur de fréquence, il est utilisé des composants déjà existants dans l'émetteur-récepteur, qui comprend ledit synthétiseur de fréquence à modulation FSK à deux points. Cela permet de gagner de la place dans la structure du circuit intégré et réduire la consommation générale du circuit pour ces opérations de calibration. Une communication par Bluetooth peut être effectuée par l'intermédiaire du synthétiseur de fréquence calibré. Il peut aussi être envisagé d'effectuer la calibration dudit synthétiseur en cours de fonctionnement de l'émetteur-récepteur, notamment lors de la modulation des données.

A cet effet, l'invention concerne également un émetteur-récepteur de signaux radiofréquences avec un synthétiseur de fréquence à modulation à deux points pour la mise en oeuvre du procédé de calibration, qui comprend les caractéristiques mentionnées dans la revendication indépendante 8.

Des formes particulières de l'émetteur-récepteur de signaux radiofréquences sont définies dans les revendications dépendantes 9 à 11.

### Brève description des dessins

Les buts, avantages et caractéristiques du procédé de calibration d'un synthétiseur de fréquence à modulation à deux points dans un émetteur-récepteur de signaux radiofréquences FSK apparaîtront mieux dans la description suivante par les dessins sur lesquels :
la figure 1 représente de manière simplifiée un émetteur-récepteur comprenant le synthétiseur de fréquence à modulation à deux points à calibrer par le procédé de calibration selon l'invention, et
la figure 2 représente partiellement le synthétiseur avec les signaux en sortie du filtre de boucle pour l'adaptation du gain du convertisseur numérique-analogique dans une seconde phase du procédé de calibration selon l'invention.

### Description détaillée de l'invention

Dans la description suivante, tous les composants du synthétiseur de fréquence à modulation à deux points notamment dans un émetteur-récepteur de signaux radiofréquences FSK pour la mise en oeuvre du procédé de calibration, qui sont bien connus d'un homme du métier dans ce domaine technique, ne sont décrits que de manière simplifiée. Principalement, il est décrit un émetteur-récepteur avec un synthétiseur de fréquence à modulation FSK à deux points.

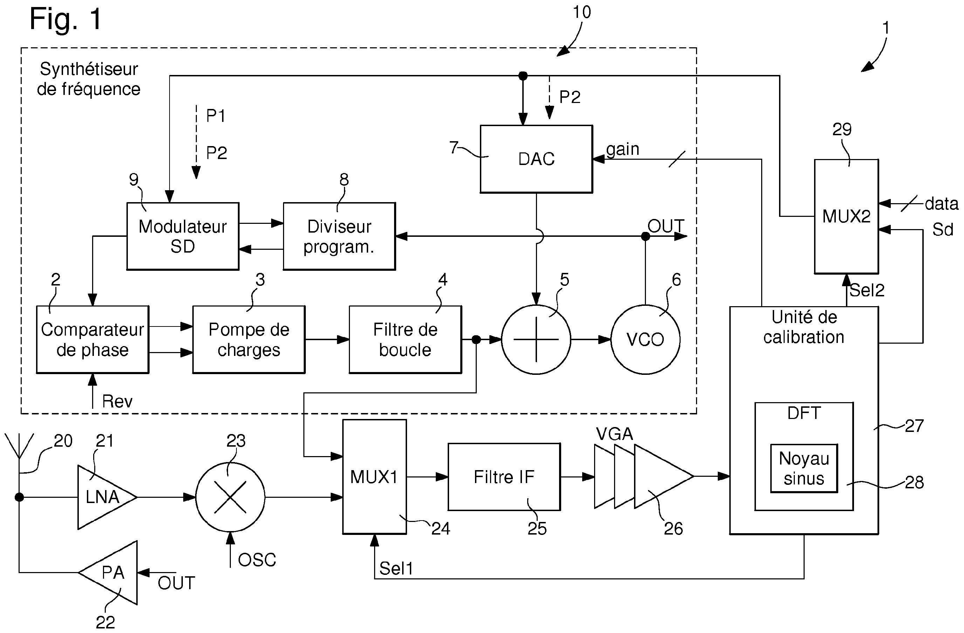

La figure 1 représente de manière générale un émetteur-récepteur 1 de signaux radiofréquences FSK, qui comprend un synthétiseur de fréquence 10 à modulation FSK à deux points. Dans un mode de fonctionnement normal, l'émetteur-récepteur 1 comprend au moins une antenne d'émission et de réception 20 de signaux radiofréquences FSK ou GFSK à une fréquence porteuse de l'ordre de 2.4 GHz. L'émetteur-récepteur 1 comprend encore un amplificateur PA de sortie 22 de signaux modulés OUT fournis en sortie du synthétiseur de fréquence 10 à transmettre par l'antenne 20, et un amplificateur de réception 21 à faible bruit LNA recevant des signaux de l'antenne 20. Les signaux amplifiés et filtrés dans l'amplificateur de réception 21 sont convertis en fréquence dans au moins un mélangeur 23 au moyen d'un signal oscillant OSC fourni par un oscillateur local non représenté. Les signaux sortant du mélangeur 23 sont des signaux intermédiaires simples ou en quadrature, qui peuvent être en bande de base. Ces signaux intermédiaires sont filtrés dans un filtre IF 25, qui est un filtre passe-bas ou à bande de base. Un amplificateur VGA 26 amplifie les signaux filtrés pour les fournir normalement à une unité de traitement non représentée pour démoduler les signaux de données reçus.

Il est à noter que généralement les signaux intermédiaires filtrés et amplifiés sont convertis numériquement dans l'unité de traitement, c'est-à-dire échantillonnés en étant cadencé par un signal d'horloge provenant d'un oscillateur de référence. Cet oscillateur de référence peut être un résonateur à quartz à 26 MHz, suivi d'une série de diviseurs par deux. Il peut être prévu par exemple 4 diviseurs par deux en série non représentés. Après cette conversion, une projection sur un des axes de la constellation des états de phase I et Q peut être également effectuée sur la base des échantillons dans l'unité de traitement. Cette projection correspond à un bin, c'est-à-dire à une fréquence unique d'une demi DFT. Cet oscillateur de référence non représenté fournit un signal de référence Ref pour le synthétiseur de fréquence 10.

Le synthétiseur de fréquence 10 peut être un synthétiseur à modulation de fréquence FSK ou GFSK à deux points. Le synthétiseur de fréquence 10 comprend principalement une boucle à verrouillage de phase basse fréquence ou passe-bas, et un accès haute fréquence relié à un oscillateur commandé en tension VCO 6 de la boucle à verrouillage de phase. L'accès haute fréquence comprend un convertisseur numérique-analogique DAC 7.

Le synthétiseur de fréquence 10 comprend donc dans la boucle à verrouillage de phase, un comparateur de phase 2. Ce comparateur 2 reçoit un signal de référence Ref d'un oscillateur de référence non représenté, mais qui peut faire partie dudit synthétiseur de fréquence, et un signal de modulation d'un modulateur sigma-delta 9. Des signaux de comparaison haut et bas en sortie du comparateur sont fournis à une pompe de charges 3, qui fournit un signal à un filtre de boucle, qui est un filtre passe-bas 4. Comme montré à la figure 1, le signal de sortie du filtre de boucle 4 est additionné dans un additionneur 5 à un signal de sortie du convertisseur DAC 7, afin de contrôler l'oscillateur commandé en tension VCO 6 à un seul varacteur dans ce cas de figure. Toutefois, il peut être imaginé d'avoir un oscillateur VCO 6 à deux varacteurs dédicacés en parallèle, qui sont indépendants l'un de l'autre, et sans l'utilisation d'un additionneur 5.

L'oscillateur commandé en tension VCO 6 est susceptible de générer un signal haute fréquence OUT. Le signal haute fréquence OUT passe encore par un diviseur programmable 8 en liaison bidirectionnelle avec le modulateur sigma-delta 9 pour fermer la boucle à verrouillage de phase. Dans un fonctionnement normal, un signal de données data est fourni par une unité de traitement au convertisseur DAC 7 et au modulateur sigma-delta 9 pour la modulation FSK à deux points par le synthétiseur de fréquence et la fourniture d'un signal haute fréquence à modulation FSK des données OUT. La fréquence porteuse du signal OUT peut être voisine de 1.2 GHz ou 2.4 GHz. Dans le cas d'une fréquence de 1.2 GHz, une multiplication de fréquence peut encore être opérée pour la transmission d'un signal à modulation FSK de données par une antenne de l'émetteur-récepteur 1 à une fréquence porteuse de 2.4 GHz.

L'émetteur-récepteur 1 comprend encore une unité de calibration 27, qui peut faire partie d'une unité de traitement non représentée. Un premier multiplexeur MUX1 24 est disposé entre la sortie du filtre de boucle 4 du synthétiseur de fréquence 10 et le filtre IF 25. Le premier multiplexeur 24 est également relié à la sortie du mélangeur 23. Un premier signal de sélection Sel1 est fourni par l'unité de calibration pour relier la sortie du filtre de boucle 4 au filtre IF 25 pour le procédé de calibration du synthétiseur de fréquence, ou de relier la sortie du mélangeur 23 au filtre IF 25 dans un mode de fonctionnement normal de l'émetteur-récepteur 1. Un second multiplexeur MUX2 29 est encore prévu et contrôlé par un second signal de sélection Sel2 de l'unité de calibration 27 pour fournir un signal d'excitation Sd de l'unité de calibration au convertisseur DAC 7 et au modulateur sigma-delta 9 pour le procédé de calibration. Dans un mode de fonctionnement normal une fois le synthétiseur calibré par exemple, un signal de données data est fourni par l'intermédiaire du second multiplexeur 29 au convertisseur DAC 7 et au modulateur sigma-delta 9.

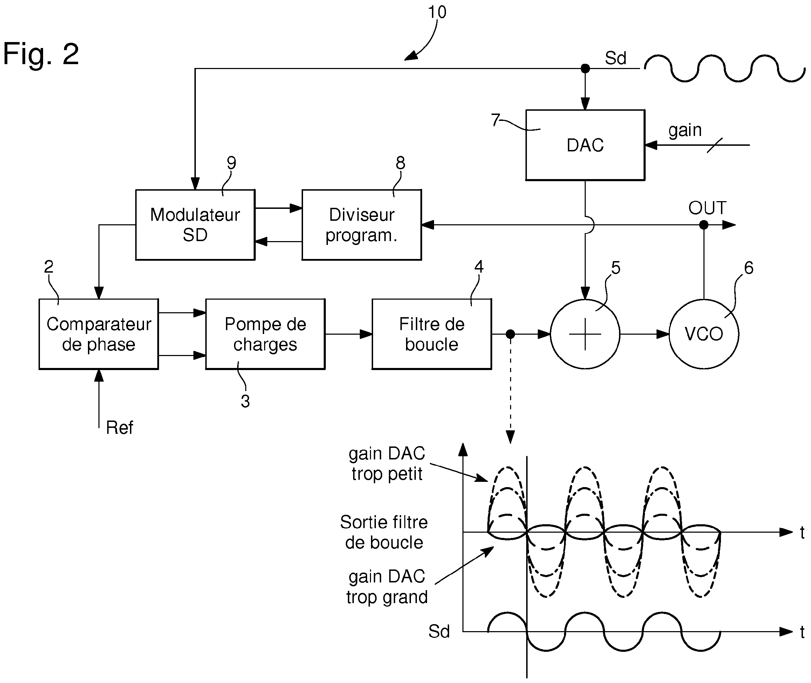

Le procédé de calibration du synthétiseur de fréquence 10 est maintenant décrit en référence aux figures 1 et 2. Le procédé de calibration comprend principalement deux phases de calibration P1 et P2. L'unité de calibration 27 transmet les premier et second signaux de sélection Sel1 et Sel2 aux deux multiplexeurs 24 et 29 pour relier la sortie du filtre de boucle 4 au filtre IF 25 et pour relier l'unité de calibration 27 au convertisseur DAC 7 et au modulateur sigma-delta 9. L'unité de calibration fournit un signal d'excitation Sd pour calibrer le synthétiseur de fréquence et principalement le convertisseur numérique-analogique 7. Ce signal d'excitation Sd peut être défini à une basse fréquence par exemple de l'ordre de 200 Hz, mais en dessous de la fréquence de coupure du filtre de boucle 4, qui se situe généralement vers 100 kHz.

Il est à noter qu'il peut être imaginé de relier directement aussi le filtre de boucle 4 à l'entrée de l'unité de calibration 27, qui convertit numériquement le signal de sortie du filtre de boucle pour effectuer la première phase P1. Dans ce cas de figure, le premier multiplexeur 24 ne serait plus nécessaire pour passer dans un mode de calibration.

Dans une première phase de calibration P1, il est réglé le décalage de phase entre le signal d'excitation Sd généré par l'unité de calibration et transmis principalement au modulateur sigma-delta 9, jusqu'à la réception du signal sortant du filtre de boucle 4 et passant par le filtre IF 25 et l'amplificateur VGA 26 dans l'unité de calibration 27. L'unité de calibration fournit un gain nul au convertisseur numérique-analogique 7 pour le désactiver dans cette première phase.

Pour le réglage du déphasage en phase P1, une unité avec son noyau 28 est intégrée dans l'unité de calibration 27 pour effectuer une projection sur un des axes de la constellation des états de phase I et Q. Cette projection peut être également effectuée sur la base des échantillons dans l'unité de traitement. Cette projection correspond à un bin, c'est-à-dire à une fréquence unique d'une demi DFT. Le signal en sortie de l'amplificateur VGA 26 est donc échantillonné à l'entrée de l'unité de calibration. Cette unité à noyau 28 permet également d'effectuer un filtrage numérique passe-bas des signaux reçus par l'intermédiaire d'un noyau au moyen d'une fenêtre temporelle d'échantillonnage de durée définie. Cela permet notamment de filtrer efficacement le bruit généré par le modulateur sigma-delta du synthétiseur 10 ou de tout autre bruit parasite.

Le signal déphasé dans cette première phase P1 est ramené dans l'unité de calibration 27 sur un des axes de la constellation des états de phase I et Q, de préférence sur l'axe I (cosinus). Ainsi une projection sur l'axe I est effectuée dans la première phase P1, ce qui correspond à une demi transformée de Fourier discrète. Il est ainsi contrôlé au moyen d'une sous-routine de l'unité de calibration, les passages par zéro du signal entrant dans ladite unité de calibration 27 à comparer au signal d'excitation Sd. Une compensation du retard ou déphasage variable est ainsi corrigé au terme de la phase P1.

Il est à noter que, comme il est utilisé le filtre IF 25 et l'amplificateur VGA 26 de l'émetteur-récepteur 1 pour la calibration du synthétiseur de fréquence 10, ces deux éléments génèrent un retard ou déphasage plus important que les autres éléments de la boucle à verrouillage de phase. Une adaptation de ce déphasage doit donc être effectuée numériquement dans l'unité de calibration 27 dans la première phase P1.

Il est encore à noter qu'en opérant cette projection du signal numérisé dans l'unité de calibration 27, on peut observer également un gain du rapport signal sur bruit SNR du signal d'excitation observé. Cela permet aussi d'effectuer une calibration fine puisque le bruit présent sur la partie Q est définitivement supprimé au terme de cette première phase. Grâce à cette première phase P1, l'alignement de phase est réalisé avec un SNR optimal. De plus comme le convertisseur numérique-analogique DAC 7 ne fonctionne pas dans cette première phase P1, la perturbation sur la sortie du filtre de boucle 4 est alors maximale. On utilise donc aussi cette première phase P1 pour optimiser la réjection utilisée dans la seconde phase P2 expliquée ci-après.

Comme le signal d'excitation est connu notamment généré dans l'unité de calibration 27, il est possible de moduler ce signal par exemple par un signal pseudo-aléatoire et de le projeter sur un vecteur modulé équivalent (corrélation). Ceci permet encore d'augmenter la réjection par rapport au bruit généré par le modulateur sigma-delta 9.

Dans une seconde phase de calibration P2, le gain du convertisseur numérique-analogique 7 est réglé facilement par un contrôle du signe ou de la polarité du signal sortant du filtre de boucle 4. Il n'est plus nécessaire dans ce cas de minimiser la puissance pour calibrer le convertisseur DAC 7. Le signe positif ou polarité positive est que le signal en sortie du filtre de boucle 4 est défini en phase avec le signal d'excitation Sd par un contrôle dans l'unité de calibration 27. Le signe négatif ou polarité négative est que le signal en sortie du filtre de boucle 4 est défini comme déphasé de 180° du signal d'excitation Sd par un contrôle dans l'unité de calibration 27.

Une adaptation par un algorithme par dichotomie peut ainsi être mise en oeuvre dans l'unité de calibration 27. Cela permet d'adapter simplement le gain du convertisseur numérique-analogique sur la base du contrôle de la polarité du signal en sortie du filtre de boucle 4. Comme montré par les graphes de la figure 2, si la polarité est définie négative, cela signifie que le gain du convertisseur DAC 7 est trop grand, alors que si la polarité est définie positive, cela signifie que le gain du convertisseur DAC 7 est trop petit. Une fois que la valeur numérique finale du gain du convertisseur DAC 7 est fournie par l'unité de calibration, le procédé de calibration se termine. La valeur numérique du gain peut être définie sur 7 bits. Avec un tel procédé de calibration du synthétiseur de fréquence à deux phases P1 et P2, il est possible d'ajuster le gain du convertisseur numérique-analogique 7 dans la seconde phase P2 entre 0.4 à 5 ms.

Au terme du procédé de calibration, il est facile de passer simplement dans un mode de fonctionnement normal en modifiant les signaux de sélection Sel1, Sel2 des multiplexeurs 24, 29. Une communication par Bluetooth peut être effectuée par l'intermédiaire du synthétiseur de fréquence calibré.

Bien entendu comme la calibration du synthétiseur est réalisée avec une grande partie des composants existants dans l'émetteur-récepteur, cela ne nécessite pas une perte de place importante dans le circuit intégré. De plus, le procédé de calibration peut être mis en fonction à tout moment dans l'émetteur-récepteur pour pouvoir calibrer ledit synthétiseur en cours de fonctionnement et avec une calibration s'opérant en boucle fermée. Cette calibration peut intervenir continument même durant la modulation des données à transmettre. Ce synthétiseur de fréquence peut être réalisé dans une technologie CMOS à 0.18 µm par exemple.

A partir de la description qui vient d'être faite, plusieurs variantes du procédé de calibration d'un synthétiseur de fréquence à modulation à deux points dans un émetteur-récepteur peuvent être conçues par l'homme du métier sans sortir du cadre de l'invention définie par les revendications. Il aurait pu être imaginé de calibrer un synthétiseur à modulation PSK ou BPSK ou QPSK selon le même procédé de calibration. Il peut être envisagé de passer en mode de réception ou transmission de signaux de données modulées à un mode calibration à tout moment du fonctionnement de l'émetteur-récepteur ou par périodes temporelles programmées.

## Revendications

1. Procédé de calibration d'un synthétiseur de fréquence (10) à modulation à deux points dans un émetteur-récepteur (1), le synthétiseur de fréquence (10) comprenant :
- une boucle à verrouillage de phase basse fréquence ou passe-bas, qui comprend au moins un comparateur de phase (2) pour comparer un signal de référence (Ref) d'un oscillateur de référence, et un signal de modulation d'un modulateur sigma-delta (9), une pompe de charges (3) reliée à la sortie du comparateur (2), un filtre de boucle (4) relié à la sortie de la pompe de charges (3), un oscillateur commandé en tension VCO (6) recevant un signal de sortie du filtre de boucle (4), et générant un signal haute fréquence (OUT), et un diviseur programmable (8) en liaison avec le modulateur sigma-delta (9) et recevant le signal haute fréquence (OUT), et
- un accès haute fréquence avec un convertisseur numérique-analogique DAC (7), qui est relié à l'oscillateur commandé en tension VCO (6) de la boucle à verrouillage de phase directement ou par l'intermédiaire d'un additionneur (5), qui opère l'addition du signal de sortie du filtre de boucle (4) et le signal de sortie du convertisseur numérique-analogique (7),
le procédé de calibration étant **caractérisé en ce qu'**il comprend les étapes de :
- dans une première phase (P1) d'un mode de calibration avec la boucle à verrouillage de phase fermée, fournir un signal périodique d'excitation (Sd) à basse fréquence généré par une unité de calibration (27) de l'émetteur-récepteur (1) au modulateur sigma-delta (9) en désactivant le convertisseur numérique-analogique (7) et transmettre le signal de sortie du filtre de boucle (4) par l'intermédiaire d'un filtre IF (25) de l'émetteur-récepteur (1) suivi par un amplificateur VGA (26) de l'émetteur-récepteur, où le filtre IF (25) et l'amplificateur VGA (26) sont utilisés en fonctionnement normal dans un mode de réception de signaux de données de l'émetteur-récepteur (1), à destination de l'unité de calibration (27), qui convertit numériquement un signal de sortie de l'amplificateur VGA (26) sur la base du signal du filtre de boucle (4), et compenser le déphasage de ce signal par rapport au signal d'excitation (Sd), et
- dans une seconde phase (P2) du mode de calibration avec la boucle à verrouillage de phase fermée, fournir le signal périodique d'excitation (Sd) à basse fréquence au modulateur sigma-delta (9) et au convertisseur numérique-analogique (7) activé, et calibrer le gain du convertisseur numérique-analogique (7) en contrôlant dans l'unité de calibration (27) le signe ou la polarité du signal de sortie du filtre de boucle (4) par rapport au signal d'excitation (Sd), et en utilisant un algorithme par dichotomie pour adapter le gain.

2. Procédé de calibration selon la revendication 1, **caractérisé en ce que** le réglage du déphasage du signal du filtre de boucle (4) dans la première phase (P1) est ramené dans l'unité de calibration (27) sur un des axes de la constellation des états de phase I et Q, de préférence sur l'axe cosinus I.

3. Procédé de calibration selon la revendication 2, **caractérisé en ce qu'**une projection est effectuée dans un noyau (28) de l'unité de calibration (27) sur la base du signal numérisé reçu notamment du filtre de boucle (4) pour pouvoir ramener le signal numérisé du filtre de boucle (4) sur l'axe cosinus I dans la première phase (P1).

4. Procédé de calibration selon la revendication 2, **caractérisé en ce qu'**en opérant une projection sur l'axe cosinus pour régler le déphasage dans le noyau (28) de l'unité de calibration (27), il est filtré le bruit généré par le modulateur sigma-delta du synthétiseur (10) tout en gagnant en rapport signal sur bruit du signal d'excitation observé.

5. Procédé de calibration selon la revendication 1, **caractérisé en ce que** l'unité de calibration (27) comprend une sous-routine pour déterminer les passages par zéro du signal numérisé du filtre de boucle (4) pour compenser le déphasage du signal du filtre de boucle par rapport au signal d'excitation (Sd).

6. Procédé de calibration selon la revendication 1, pour lequel l'émetteur-récepteur (1) comprend un premier multiplexeur (24) disposé entre un mélangeur (23) de conversion de fréquence de signaux radiofréquences reçus et le filtre IF (25), le premier multiplexeur (24) recevant en entrée le signal du filtre de boucle (4) et au moins un signal converti du mélangeur (23) en étant commandé par un premier signal de sélection (Sel1) de l'unité de calibration (27), et un second multiplexeur (29) disposé entre l'unité de calibration (27) et le synthétiseur de fréquence (10), le second multiplexeur (29) recevant en entrée le signal d'excitation (Sd) de l'unité de calibration (27) et un signal de données de modulation (data) en étant commandé par un second signal de sélection (Sel2) de l'unité de calibration (27),
**caractérisé en ce que** dans un mode de calibration, les premier et second multiplexeurs (24, 29) sont contrôlés par les premier et second signaux de sélection (Sel1, Sel2) de manière à relier le filtre de boucle (4) au filtre IF (25) à travers le premier multiplexeur (24), et à fournir le signal d'excitation (Sd) au synthétiseur de fréquence (10) à travers le second multiplexeur (29), et **en ce qu'**une fois que le gain du convertisseur numérique-analogique (7) est calibré dans la seconde phase (P2), une sélection d'un mode de fonctionnement normal est effectuée en reliant la sortie du mélangeur (23) au filtre IF (25) à travers le premier multiplexeur (24), et transmettant le signal de données de modulation (data) au synthétiseur de fréquence (10) à travers le second multiplexeur (29).

7. Emetteur-récepteur (1) de signaux radiofréquences, qui comprend un synthétiseur de fréquence (10) à modulation à deux points convenant à la mise en oeuvre du procédé de calibration selon l'une des revendications précédentes, l'émetteur-récepteur (1) comprenant au moins une unité de calibration (27) pour adapter le déphasage entre un signal d'excitation (Sd) transmis au synthétiseur de fréquence (10) en mode de calibration et au moins un signal de sortie d'un filtre de boucle (4) dans l'unité de calibration (27), et calibrer le gain d'un convertisseur numérique-analogique (7) par un algorithme par dichotomie, et pour lequel le synthétiseur de fréquence (10) comprend :
- une boucle à verrouillage de phase basse fréquence ou passe-bas, qui comprend au moins un comparateur de phase (2) pour comparer un signal de référence (Ref) d'un oscillateur de référence, et un signal de modulation d'un modulateur sigma-delta (9), une pompe de charges (3) reliée à la sortie du comparateur (2), un filtre de boucle (4) relié à la sortie de la pompe de charges (3), un oscillateur commandé en tension VCO (6) recevant un signal de sortie du filtre de boucle (4), et générant un signal haute fréquence (OUT), et un diviseur programmable (8) en liaison avec le modulateur sigma-delta (9) et recevant le signal haute fréquence (OUT), et
- un accès haute fréquence avec le convertisseur numérique-analogique DAC (7), qui est relié à l'oscillateur commandé en tension VCO (6) de la boucle à verrouillage de phase directement ou par l'intermédiaire d'un additionneur (5), qui opère l'addition du signal de sortie du filtre de boucle (4) et le signal de sortie du convertisseur numérique-analogique (7),
**caractérisé en ce que** l'émetteur-récepteur comprend un filtre IF (25) pour recevoir un signal de sortie du filtre de boucle (4), suivi par un amplificateur VGA (26), pour la transmission du signal du filtre de boucle (4) à l'unité de calibration (27), le signal d'excitation (Sd) étant fourni de l'unité de calibration (27) au convertisseur numérique-analogique DAC (7) et au modulateur sigma-delta (9) pour le procédé de calibration,
**en ce que** le filtre IF (25) et l'amplificateur VGA (26) sont destinés à être utilisés en fonctionnement normal dans un mode de réception de signaux de données de l'émetteur-récepteur (1), et
**en ce qu'**un signal de données (data) est destiné à être fourni au convertisseur numérique-analogique DAC (7) et au modulateur sigma-delta (9) par l'intermédiaire d'un modulateur (29) dans un mode de fonctionnement normal de l'émetteur-récepteur (1).

8. Emetteur-récepteur (1) selon la revendication 7, **caractérisé en ce que** l'émetteur-récepteur (1) comprend un premier multiplexeur (24) disposé entre un mélangeur (23) de conversion de fréquence de signaux radiofréquences reçus par une antenne (20) et amplifiés par un amplificateur à faible bruit (21), et le filtre IF (25), le premier multiplexeur (24) recevant en entrée le signal du filtre de boucle (4) et au moins un signal converti du mélangeur (23) en étant commandé par un premier signal de sélection (Sel1) de l'unité de calibration (27), et un second multiplexeur (29) disposé entre l'unité de calibration (27) et le synthétiseur de fréquence (10), le second multiplexeur (29) recevant en entrée le signal d'excitation (Sd) de l'unité de calibration (27) et un signal de données de modulation (data) en étant commandé par un second signal de sélection (Sel2) de l'unité de calibration (27), et **en ce que** l'émetteur-récepteur (1) est configurable dans un mode de réception et transmission de signaux de données par l'intermédiaire des premier et second multiplexeurs (24, 29) commandés par les premier et second signaux de sélection (Sel1, Sel2) ou dans un mode de calibration en reliant le synthétiseur de fréquence (10) à l'unité de calibration (27).

9. Emetteur-récepteur (1) selon la revendication 7, **caractérisé en ce qu'**il peut être configuré de telle manière à passer continument d'un mode de réception, voire d'un mode de transmission à un mode de calibration.

## Patentansprüche

1. Verfahren zum Kalibrieren eines Frequenzsynthesizers (10) mit Zwei-Punkt-Modulation in einem Sender/Empfänger (1), wobei der Frequenzsynthesizer (10) umfasst:
- eine Niederfrequenz- oder Tiefpass-Phasenregelschleife, umfassend mindestens einen Phasenkomparator (2) zum Vergleichen eines Referenzsignals (Ref) eines Referenzoszillators und eines Modulationssignals eines Sigma/Delta-Modulators (9), eine Ladungspumpe (3), die mit dem Ausgang des Komparators (2) verbunden ist, ein Loop-Filter (4), das mit dem Ausgang der Ladungspumpe (3) verbunden ist, einen spannungsgesteuerten Oszillator VCO (6), der ein Ausgangssignal des Loop-Filters (4) empfängt und ein Hochfrequenzsignal (OUT) erzeugt, und einen programmierbaren Teiler (8), der mit dem Sigma/Delta-Modulator (9) verbunden ist und das Hochfrequenzsignal (OUT) empfängt, und
- einen Hochfrequenzzugang mit einem Digital/Analog-Konverter DAC (7), der mit dem spannungsgesteuerten Oszillator VCO (6) der Phasenregelschleife direkt oder über einen Addierer (5) verbunden ist, der die Addition des Ausgangssignals des Loop-Filters (4) und des Ausgangssignals des Digital/Analog-Konverters (7) ausführt,
wobei das Kalibrierungsverfahren **dadurch gekennzeichnet ist, dass** es die Schritte umfasst:
- in einer ersten Phase (P1) einer Kalibrierungsbetriebsart mit geschlossener Phasenregelschleife Ausgeben eines periodischen Erregungssignals (Sd) mit niedriger Frequenz, das von einer Kalibrierungseinheit (27) des Sender/Empfängers (1) erzeugt wird, an den Sigma/Delta-Modulator (9) unter Deaktivierung des Digital/Analog-Konverters (7) und Übertragen des Ausgangssignals des Loop-Filters (4) über ein ZF-Filter (25) des Sender/Empfängers (1), dem ein Verstärker VGA (26) des Sender/Empfängers nachgeschaltet ist, wobei das ZF-Filter (25) und der Verstärker VGA (26) im Normalbetrieb in einer Empfangsbetriebsart für Datensignale des Sender/Empfängers (1) verwendet werden, zu der Kalibrierungseinheit (27), die ein Ausgangssignal des Verstärkers VGA (26) auf der Grundlage des Signals des Loop-Filters (4) digital umsetzt, und Vergleichen der Phasenverschiebung dieses Signals in Bezug auf das Erregungssignal (Sd) und
- in einer zweiten Phase (P2) der Kalibrierungsbetriebsart bei geschlossener Phasenregelschleife Ausgeben des periodischen Erregungssignals (Sd) mit niedriger Frequenz an den Sigma/Delta-Modulator (9) und an den aktivierten Digital/Analog-Konverter (7) und Kalibrieren der Verstärkung des Digital/Analog-Konverters (7) durch Steuern des Vorzeichens oder der Polarität des Ausgangssignals des Loop-Filters (4) in Bezug auf das Erregungssignal (Sd) in der Kalibrierungseinheit (27) und unter Verwendung eines dichotomen Algorithmus, um die Verstärkung anzupassen.

2. Kalibrierungsverfahren nach Anspruch 1, **dadurch gekennzeichnet, dass** die Regulierung der Phasenverschiebung des Signals des Loop-Filters (4) in der ersten Phase (P1) in der Kalibrierungseinheit (27) auf eine der Achsen der Konstellation der Phasenzustände I und Q, vorzugsweise auf die Kosinusachse I, zurückgeführt wird.

3. Kalibrierungsverfahren nach Anspruch 2, **dadurch gekennzeichnet, dass** eine Projektion in einem Kern (28) der Kalibrierungseinheit (27) auf der Grundlage des insbesondere von dem Loop-Filter (4) empfangenen digitalisierten Signals ausgeführt wird, um das digitalisierte Signal des Loop-Filters (4) in der ersten Phase (P1) auf die Kosinusachse I zurückführen zu können.

4. Kalibrierungsverfahren nach Anspruch 2, **dadurch gekennzeichnet, dass** bei Ausführung einer Projektion auf die Kosinusachse, um die Phasenverschiebung in dem Kern (28) der Kalibrierungseinheit (27) zu regulieren, das durch den Sigma/Delta-Modulator des Synthesizers (10) erzeugte Rauschen gefiltert wird und dabei der Rauschabstand des beobachteten Erregungssignals verbessert wird.

5. Kalibrierungsverfahren nach Anspruch 1, **dadurch gekennzeichnet, dass** die Kalibrierungseinheit (27) eine Unterroutine zur Bestimmung der Nulldurchgänge des digitalisierten Signals des Loop-Filters (4) enthält, um die Phasenverschiebung des Signals des Loop-Filters in Bezug auf das Erregungssignal (Sd) zu kompensieren.

6. Kalibrierungsverfahren nach Anspruch 1, wobei der Sender/Empfänger (1) einen ersten Multiplexer (24) umfasst, der zwischen einem Frequenzkonvertermischer (23) der empfangenen Signale und dem ZF-Filter (25) angeordnet ist, wobei der erste Multiplexer (24) am Eingang das Signal des Loop-Filters (4) und mindestens ein umgesetztes Signal des Mischers (23) empfängt und dabei durch ein erstes Auswahlsignal (Sel1) der Kalibrierungseinheit (27) gesteuert wird, und einen zweiten Multiplexer (29) umfasst, der zwischen der Kalibrierungseinheit (27) und dem Frequenzsynthesizer (10) angeordnet ist, wobei der zweite Multiplexer (29) am Eingang das Erregungssignal (Sd) der Kalibrierungseinheit (27) und ein Modulationsdatensignal (data) empfängt und dabei durch ein zweites Auswahlsignal (Sel2) der Kalibrierungseinheit (27) gesteuert wird,
**dadurch gekennzeichnet, dass** in einer Kalibrierungsbetriebsart der erste und der zweite Multiplexer (24, 29) durch das erste und das zweite Auswahlsignal (Sel1, Sel2) in der Weise gesteuert werden, dass das Loop-Filter (4) mit dem ZF-Filter (25) über den ersten Multiplexer (24) verbunden wird, und dass das Erregungssignal (Sd) an den Frequenzsynthesizer (10) über den zweiten Multiplexer (29) ausgegeben wird und dass, sobald die Verstärkung des Digital/Analog-Konverters (7) in der zweiten Phase (P2) kalibriert ist, die Auswahl einer normalen Betriebsart erfolgt, indem der Ausgang des Mischers (23) mit dem ZF-Filter (25) über den ersten Multiplexer (24) verbunden wird und das Modulationsdatensignal (data) an den Frequenzsynthesizer (10) über den zweiten Multiplexer (29) übertragen wird.

7. Sender/Empfänger (1) für Hochfrequenzsignale, der einen Frequenzsynthesizer (10) mit Zwei-Punkt-Modulation umfasst, der geeignet ist, das Kalibrierungsverfahren nach einem der vorhergehenden Ansprüche auszuführen, wobei der Sender/Empfänger (1) mindestens eine Kalibrierungseinheit (27) umfasst, um die Phasenverschiebung zwischen einem Erregungssignal (Sd), das an den Frequenzsynthesizer (10) in einer Kalibrierungsbetriebsart übertragen wird, und mindestens einem Ausgangssignal eines Loop-Filters (4) in der Kalibrierungseinheit (27) anzupassen und die Verstärkung eines Digital/Analog-Konverters (7) durch einen dichotomen Algorithmus zu kalibrieren, wofür der Frequenzsynthesizer (10) umfasst:
- eine Niederfrequenz- oder Tiefpass-Phasenregelschleife, umfassend mindestens einen Phasenkomparator (2) zum Vergleichen eines Referenzsignals (Ref) eines Referenzoszillators und eines Modulationssignals eines Sigma/Delta-Modulators (9), eine Ladungspumpe (3), die mit dem Ausgang des Komparators (2) verbunden ist, ein Loop-Filter (4), das mit dem Ausgang der Ladungspumpe (3) verbunden ist, einen spannungsgesteuerten Oszillator VCO (6), der ein Ausgangssignal des Loop-Filters (4) empfängt und ein Hochfrequenzsignal (OUT) erzeugt, und einen programmierbaren Teiler (8), der mit dem Sigma/Delta-Modulator (9) verbunden ist und das Hochfrequenzsignal (OUT) empfängt, und
- einen Hochfrequenzzugriff mit dem Digital/Analog-Konverter DAC (7), der mit dem spannungsgesteuerten Oszillator VCO (6) der Phasenregelschleife direkt oder über einen Addierer (5) verbunden ist, der die Addition des Ausgangssignals des Loop-Filters (4) und des Ausgangssignals des Digital/Analog-Konverters (7) ausführt,
**dadurch gekennzeichnet, dass** der Sender/Empfänger ein ZF-Filter (25) umfasst, um ein Ausgangssignal des Loop-Filters (4) zu empfangen, gefolgt von einem Verstärker VGA (26), um das Signal des Loop-Filters (4) an die Kalibrierungseinheit (27) zu übertragen, wobei das Erregungssignal (Sd) von der Kalibrierungseinheit (27) an den Digital/Analog-Konverter DAC (7) und an den Sigma/Delta-Modulator (9) für das Kalibrierungsverfahren ausgegeben wird,
dass das ZF-Filter (25) und der Verstärker VGA (26) dazu bestimmt sind, im Normalbetrieb in einer Empfangsbetriebsart für Datensignale des Sender/Empfängers (1) verwendet zu werden, und
dass ein Datensignal (data) dazu bestimmt ist, in einer normalen Betriebsart des Sender/Empfängers (1) an den Digital/Analog-Konverter DAC (7) und an den Sigma/Delta-Modulator (9) über einen Modulator (29) ausgegeben zu werden.

8. Sender/Empfänger (1) nach Anspruch 7, **dadurch gekennzeichnet, dass** der Sender/Empfänger (1) einen ersten Multiplexer (24), der zwischen einem Frequenzkonvertermischer (23) für Hochfrequenzsignale, die über eine Antenne (20) empfangen und durch einen Verstärker (21) mit geringem Rauschen verstärkt werden, und dem ZF-Filter (25) angeordnet ist, wobei der erste Multiplexer (24) am Eingang das Signal des Loop-Filters (4) und mindestens ein umgesetztes Signal des Mischers (23) empfängt und dabei durch ein erstes Auswahlsignal (Sel1) der Kalibrierungseinheit (27) gesteuert wird, und einen zweiten Multiplexer (29), der zwischen der Kalibrierungseinheit (27) und dem Frequenzsynthesizer (10) angeordnet ist, umfasst, wobei der zweite Multiplexer (29) am Eingang das Erregungssignal (Sd) der Kalibrierungseinheit (27) und ein Modulationsdatensignal (data) empfängt und dabei durch ein zweites Auswahlsignal (Sel2) der Kalibrierungseinheit (27) gesteuert wird, und dass der Sender/Empfänger (1) in einer Betriebsart zum Empfangen und Übertragen von Datensignalen über den ersten und den zweiten Multiplexer (24, 29), die durch das erste und das zweite Auswahlsignal (Sel1, Sel2) gesteuert werden, oder in einer Kalibrierungsbetriebsart durch Verbinden des Frequenzsynthesizers (10) mit der Kalibrierungseinheit (27) konfigurierbar ist.

9. Sender/Empfänger (1) nach Anspruch 7, **dadurch gekennzeichnet, dass** er in einer Weise konfigurierbar ist, dass er ununterbrochen von einer Empfangsbetriebsart oder sogar von einer Sendebetriebsart in eine Kalibrierungsbetriebsart übergeht.

## Claims

1. Method for calibrating a frequency synthesiser (10) using two-point modulation in a transceiver (1), the frequency synthesiser (10) comprising:
- a low-frequency or low-pass phase-locked loop, which comprises at least one phase comparator (2) for comparing a reference signal (Ref) from a reference oscillator, and a modulation signal from a sigma-delta modulator (9), a charge pump (3) connected to the output of the comparator (2), a loop filter (4) connected to the output of the charge pump (3), a voltage-controlled oscillator VCO (6) receiving an output signal from the loop filter (4), and generating a high frequency signal (OUT), and a programmable divider (8) connected to the sigma-delta modulator (9) and receiving the high frequency signal (OUT), and
- a high frequency access with a digital-to-analogue converter DAC (7), which is connected to the voltage-controlled oscillator VCO (6) of the phase-locked loop directly or via an adder (5), which performs the addition of the output signal from the loop filter (4), and the output signal from the digital-to-analogue converter (7),
the calibration method being **characterized in that** it includes the following steps:
- in a first phase (P1) of a calibration mode with the phase-locked loop closed, supplying a periodic excitation signal (Sd) at low frequency generated by a calibration unit (27) of the transceiver (1) to the sigma-delta modulator (9) by deactivating the digital-to-analogue converter (7) and transmitting the output signal from the loop filter (4) via an IF filter (25) of the transceiver (1) followed by a VGA amplifier (26) of the transceiver, where the IF filter (25) and the VGA amplifier (26) are used in normal operation in a reception mode of data signals from the transceiver (1) to the calibration unit (27), which digitally converts an output signal from the VGA amplifier (26) based on the signal from the loop filter (4), and offsetting the phase shift of this signal with respect to the excitation signal (Sd), and
- in a second phase (P2) of the calibration mode with the phase-locked loop closed, supplying the periodic excitation signal (Sd) at low frequency to the sigma-delta modulator (9) and to the activated digital-to-analogue converter (7), and calibrating the gain of the digital-to-analogue converter (7), by checking in the calibration unit (27), the sign or the polarity of the output signal from the loop filter (4) with respect to the excitation signal (Sd), and using a dichotomy algorithm to adjust the gain.

2. Calibration method according to claim 1, **characterized in that** adjustment of the phase shift of the signal from the loop filter (4) in the first phase (P1) is brought back in the calibration unit (27) onto either the in-phase or quadrature axes of the constellation, preferably onto the I-axis (cosine).

3. Calibration method according to claim 2, **characterized in that** a projection is made in a core (28) of the calibration unit (27) based on the digitized signal received in particular from the loop filter (4) in order to return the digitized signal from the loop filter (4) onto the I-axis (cosine) in the first phase (P1).

4. Calibration method according to claim 2, **characterized in that** making a projection onto the cosine axis to adjust the phase shift in the core (28) of the calibration unit (27), it is filtered the noise generated by the sigma-delta modulator of the synthesiser (10) while increasing the signal noise ratio of the observed excitation signal.

5. Calibration method according to claim 1, **characterized in that** the calibration unit (27) includes a subroutine for determining zero crossings of the digitized signal from the loop filter (4) to offset the phase shift of the loop filter signal with respect to the excitation signal (Sd).

6. Calibration method according to claim 1, wherein the transceiver (1) includes a first multiplexer (24) disposed between a mixer (23) for converting the frequency of incoming RF signals and the IF filter (25), the first multiplexer (24) receiving at input the signal from the loop filter (4) and at least one converted signal from the mixer (23) while being controlled by a first selection signal (Sel1) from the calibration unit (27), and a second multiplexer (29) disposed between the calibration unit (27) and the frequency synthesiser (10), the second multiplexer (29) receiving at input the excitation signal (Sd) from the calibration unit (27) and a data modulation signal (data) while being controlled by a second selection signal (Sel2) from the calibration unit (27),
**characterized in that**, in calibration mode, the first and second multiplexers (24, 29) are controlled by the first and second selection signals (Sell, Sel2) to connect the loop filter (4) to the IF filter (25) via the first multiplexer (24), and to supply the excitation signal (Sd) to the frequency synthesiser (10) via the second multiplexer (29), and **in that** once the gain of the digital-to-analogue converter (7) is calibrated in the second phase (P2), a normal operating mode is selected by connecting the output of the mixer (23) to the IF filter (25) via the first multiplexer (24), and transmitting the data modulation signal (data) to the frequency synthesiser (10) via the second multiplexer (29).

7. RF signal transceiver (1), which includes a frequency synthesiser (10) using two-point modulation suitable for implementing the calibration method according to any of the preceding claims, the transceiver (1) comprising at least one calibration unit (27) for adjusting the phase shift of an excitation signal (Sd) transmitted to the frequency synthesiser (10) in calibration mode, and at least an output signal from the loop filter (4) in the calibration unit (27) and calibrating the gain of a digital-to-analogue converter (7) by dichotomy algorithm, and wherein the frequency synthesiser (10) includes:
- a low-frequency or low-pass phase-locked loop, which comprises at least one phase comparator (2) for comparing a reference signal (Ref) from a reference oscillator, and a modulation signal from a sigma-delta modulator (9), a charge pump (3) connected to the output of the comparator (2), a loop filter (4) connected to the output of the charge pump (3), a voltage-controlled oscillator VCO (6) receiving an output signal from the loop filter (4), and generating a high frequency signal (OUT), and a programmable divider (8) connected to the sigma-delta modulator (9) and receiving the high frequency signal (OUT), and
- a high frequency access with the digital-to-analogue converter DAC (7), which is connected to the voltage-controlled oscillator VCO (6) of the phase-locked loop directly or via an adder (5), which performs the addition of the output signal from the loop filter (4), and the output signal from the digital-to-analogue converter (7),
**characterized in that** the transceiver includes an IF filter (25) for receiving an output signal from the loop filter (4), followed by a VGA amplifier (26), for transmission of the signal from the loop filter (4) to the calibration unit (27), the excitation signal (Sd) being supplied from the calibration unit (27) to the digital-to-analogue converter DAC (7) and to the sigma-delta modulator (9) for the calibration method, and **in that** the IF filter (25) and the VGA amplifier (26) are intended to be used in normal operation in a data reception mode of the transceiver (1), and **in that** a data signal (data) is intended to be supplied to the digital-to-analogue converter DAC (7) and to the sigma-delta modulator (9) via a modulator (29) in a normal operating mode of the transceiver (1).

8. Transceiver (1) according to claim 7, **characterized in that** the transceiver (1) includes a first multiplexer (24) disposed between a mixer (23) for converting the frequency of incoming RF signals received by an antenna (20) and amplified by a low noise amplifier (21), and the IF filter (25), the first multiplexer (24) receiving at input the signal from the loop filter (4) and at least one converted signal from the mixer (23) while being controlled by a first selection signal (Sel1) from the calibration unit (27), and a second multiplexer (29) disposed betwen the calibration unit (27) and the frequency synthesiser (10), the second multiplexer (29) receiving at input the excitation signal (Sd) from the calibration unit (27) and a data modulation signal (data) while being controlled by a second selection signal (Sel2) from the calibration unit (27), and **in that** the transceiver (1) can be configured in a data reception and transmission mode via the first and second multiplexers (24, 29) controlled by the first and second selection signals (Sel1, Sel2) or in a calibration mode by connecting the frequency synthesiser (10) to the calibration unit (27).

9. Transceiver (1) according to claim 7, **characterized in that** the transceiver can be configured to change continuously from a reception mode, or a transmission mode, to a calibration mode.
